# EUROPEAN PATENT APPLICATION

(11) **EP 4 803 352 A1**
(43) Date of publication of application: **09.09.2026**
(21) Application number: 24884424.3
(22) Date of filing: 15.10.2024
(51) Int. Cl.: B60L 53/22, H05K 9/00

(54) **ON-BOARD CHARGER, ON-BOARD POWER SUPPLY DEVICE AND VEHICLE**

(30) Priority: 31.10.2023 CN 202322938264 U
(71) Applicant: BYD Company Limited, Shenzhen, Guangdong 518118 (CN)
(72) Inventor: XING, Ruili, Shenzhen, Guangdong 518118 (CN); LI, Xiaokuang, Shenzhen, Guangdong 518118 (CN); CHEN, Fangbing, Shenzhen, Guangdong 518118 (CN)
(74) Representative: Mathys & Squire
(86) International application number: PCT/CN2024/125007
(87) International publication number: WO 2025/092420

(57) **Abstract**

An on-board charger (1008), an on-board power supply device (1003) and a vehicle. The on-board charger (1008) comprises a housing (100), a circuit board (200), a filtering module (300) and a sealing member. The housing (100) comprises a first side surface (110) and a second side surface (120) arranged opposite to each other. A first cavity (130) is recessed from the first side surface (110), a second cavity (140) is recessed from the second side surface (120), and the first cavity (130) is spaced apart from the second cavity (140). The circuit board (200) is provided in the first cavity (130). The filtering module (300) is provided in the second cavity (140), and the filtering module (300) is electrically connected to the circuit board (200). The sealing member is connected to the housing (100).

## Description

### CROSS-REFERENCE TO RELATED APPLICATIONS

The present disclosure claims priority to Chinese Patent Application No. 202322938264.9 filed on October 31, 2023 and entitled "ON-VEHICLE CHARGER, ON-BOARD POWER SUPPLY DEVICE, AND VEHICLE", which is incorporated herein by reference in its entirety.

### FIELD

The present disclosure relates to the technical field of vehicles, in particular to an on-board charger, an on-board power supply device and a vehicle.

### BACKGROUND

With the increasing demand for energy conservation, emissions reduction and control of atmospheric pollution, the automotive industry needs to transform its energy structure as soon as possible. At present new energy vehicles are gradually becoming commercially available in the market, and electric vehicles are the main force of new energy vehicles, with great future development potential and market demand. The on-board power supply, including an on-board charger (OBC), an on-board DC/DC converter, and a high voltage power distribution box (PDU), is an important component of electric vehicle charging systems; wherein the on-board charger is a charger fixedly installed on the electric vehicle, which takes AC power as input and outputs DC power, charging the power battery directly, and realizing safe and automatic charging of the electric vehicle power battery.

In the prior art, an electromagnetic interference (EMI) filter module of the on-board charger and the main power board are mounted within the same large aluminum alloy cavity, and a shielding cover is mounted between the electromagnetic interference (EMI) filter module and the main power board to achieve shielding of the electromagnetic interference (EMI) filter module; when this method is adopted, there is a gap between the circumference of the shield cover and the housing, which poorly shields the electromagnetic interference (EMI) filter module and affects the electromagnetic compatibility (EMC) index of the whole machine.

### SUMMARY

An object of the present disclosure is to provide an on-board charger, an on-board power supply device, and a vehicle to solve the problem that the shielding effect of the electromagnetic interference (EMI) filter module is poor and affects the electromagnetic compatibility (EMC) index of the whole machine.

To achieve the purposes of the present disclosure, the present disclosure provides the following technical solutions:
In a first aspect, the present disclosure provides an on-board charger including:
a housing including a first side surface and a second side surface arranged opposite to each other, a first cavity recessed from the first side surface, a second cavity recessed from the second side surface, and the first cavity is spaced apart from the second cavity (140);
a circuit board arranged in the first cavity;
a filtering module arranged in the second cavity, and electrically connected to the circuit board; and
a sealing member connected to the housing to enclose the circuit board within the first cavity and the filtering module within the second cavity.

In one embodiment, the first side surface and the second side surface are spaced apart along height direction of the housing, and an inner wall of the first cavity is spaced from an inner wall of the second cavity in a height direction of the housing.

In one embodiment, the on-board charger further includes a magnetic element module, wherein the filtering module includes a DC filtering module and an AC filtering module, the second cavity includes a plurality of mutually isolated chambers, and the plurality of chambers includes a first chamber, a second chamber and a third chamber, and the DC filtering module is arranged in the first chamber, the AC filtering module is arranged in the second chamber, and the magnetic element module is arranged in the third chamber.

In one embodiment, a plurality of through holes are arranged on an inner wall of the first cavity, the plurality of through holes include a first through hole that communicates the first cavity with the first chamber, a second through hole that communicates the first cavity with the second chamber, and a third through hole that communicates the first cavity with the third chamber.

In one embodiment, a first conductive piece is arranged on the DC filtering module, one end of the first conductive piece is connected to the circuit board through the first through hole; a second conductive piece is arranged on the AC filtering module, one end of the second conductive piece is connected to the circuit board through the second through hole; and a third conductive piece being arranged on the magnetic element module, one end of the third conductive piece being connected to the circuit board through the third through hole.

In one embodiment, the plurality of chambers are sequentially spaced apart along width direction of the housing.

In one embodiment, the sealing member includes a first sealing lid and a second sealing lid, the first sealing lid enclosing the circuit board within the first cavity; and
the second sealing lid includes a first lid plate, a second lid plate and a third lid plate, the first lid plate enclosing the DC filtering module within the first chamber, the second lid plate enclosing the AC filtering module within the second chamber, and the third lid enclosing the magnetic element module within the third chamber.

In one embodiment, the first lid plate is mounted in the first chamber, and a side surface of the first lid plate away from the first side surface is in the same plane with the second side surface; the second lid plate is mounted in the second chamber, a side surface of the second lid plate away from the first side surface is in the same plane with the second side surface; and the third lid plate is mounted in the third chamber, a side surface of the third lid plate away from the first side surface is in the same plane with the second side surface.

In one embodiment, the on-board charger further includes a plurality of connection terminals, the plurality of connection terminals being fixed to the housing and/or to the sealing member.

In one embodiment, the plurality of connection terminals includes a first connection terminal, a second connection terminal, and a third connection terminal; one end of the first connection terminal extending into the first cavity to be in electrical connection with the circuit board, one end of the second connection terminal extending into the first cavity to be in electrical connection with the DC filtering module, and one end of the third connection terminal extending into the second cavity to be in electrical connection with the AC filtering module.

In one embodiment, an end of the first connection terminal away from the circuit board is connected to a system of the vehicle through a wire, an end of the second connection terminal away from the DC filtering module is connected to a power battery of the vehicle through a wire to output power to the power battery (1002), and an end of the third connection terminal away from the AC filtering module (320) is connected to a charging port socket of the vehicle through a wire.

In one embodiment, the first connection terminal, the second connection terminal and the third connection terminal are located at the same end in length direction of the housing; or, the first connection terminal, the second connection terminal, the third connection terminal are located at the same end in length direction of the sealing member.

In a second aspect, the present disclosure also provides an on-board power supply device comprising an on-board converter, a high voltage power distribution box, and an on-board charger as described above.

In one embodiment, the on-board converter is for converting high-voltage side energy of the power battery of the vehicle into low-voltage side energy; the high-voltage power distribution box is for distributing high-voltage electrical energy of the power battery; and the on-board charger is connected between a charging port socket of the vehicle and the power battery, and is configured to charge the power battery.

In a third aspect, the present disclosure also provides a vehicle, includes a vehicle body, a power battery, a charging port socket, and an on-board power supply device described above; the on-board power supply device, the power battery and the charging port socket are mounted on the vehicle body, the on-board charger is connected between the charging port socket and the power battery of the vehicle, and the on-board charger is configured to charge the power battery.

An on-board charger according to an embodiment of the present disclosure, a first cavity and a second cavity are formed by respectively recessed on first side surface and a second side surface of opposite sides of the housing, a circuit board and a filtering module are accommodated in a first cavity and a second cavity, respectively, the circuit board and the filtering module are isolated by the housing itself, and the circuit board and the filtering module are sealed in the first cavity and the second cavity, respectively, by means of the sealing member, thus achieving isolation of the circuit board from the filtering module to improve the shielding effect of the filtering module and improve the electromagnetic compatibility (EMC) of the on-board charger.

### BRIEF DESCRIPTION OF THE DRAWINGS

In order to illustrate more clearly the embodiments of the present disclosure or the technical solutions in the prior art, the drawings required for use in the description of the embodiments or prior art will be briefly described below. Obviously, drawings described below are only some embodiments of the present disclosure and that other drawings can be obtained from these drawings without inventive step for a person of ordinary skill in the art.
FIG. 1 is a perspective view of an on-board charger in accordance with an embodiment of the present disclosure.
FIG. 2 is a bottom view of FIG. 1.
FIG. 3 is a cross-sectional view taken along line A-A of FIG. 2.
FIG. 4 is a perspective view of the housing in accordance with an embodiment of the present disclosure.
Fig. 5 is an exploded view of the on-board charger in accordance with an embodiment of the present disclosure.
FIG. 6 is another exploded view of the on-board charger in accordance with an embodiment of the present disclosure.
FIG. 7 is a bottom view of FIG. 4.
FIG. 8 is cross-sectional taken along line B-B of FIG. 7.
FIG. 9 is a schematic structural diagram of the on-board power supply apparatus in accordance with an embodiment of the present disclosure.
FIG. 10 is a schematic structural diagram of a vehicle in accordance with an embodiment of the present disclosure.

### Explanation of reference numerals:

100,housing; 110, a first side surface; 120, a second side surface; 130, a first cavity; 131, a first through hole; 132, a second through hole; 133, a third through hole; 140, a second cavity; 141, a first chamber; 142, a second chamber; 143, a third chamber; 200, a circuit board; 300, a filtering module; 310, a DC filtering module; 320, a AC filtering module; 400, a first sealing lid; 500, a second sealing lid; 510, a first lid plate; 520, a second lid plate; 530, a third lid plate; 600, a magnetic element module; 610, a third conductive piece; 620, a first conductive piece; 630, a second conductive piece; 700, a first connection terminal; 800, a second connection terminal; 900, a third connection terminal; 1000, a vehicle; 1001, a vehicle body; 1002, a power battery; 10, a vehicle windshield; 1003, an on-board power supply device; 1004, an on-board converter; 1006, a high voltage power distribution box; 1008, an on-board charger; 1010, a charging port socket.

### DETAILED DESCRIPTION

The technical solutions in the embodiments of the present disclosure will be clearly and completely described below combining with drawings in the embodiments of the present disclosure. Obviously, the described embodiments are only some, but not all, embodiments of the present disclosure. All other embodiments obtained by a person of ordinary skill in the art without inventive step based on the embodiments of the present disclosure are intended to be within the scope of protection of the present disclosure.

It will be noted that when component is referred to as being "fixed" to another component, it can be directly on other component or there can be a central component. When component is referred to as being "connected" to other component, it can be directly connected to the other component or there can be a central component at same time.

Unless otherwise defined, all technical and scientific terms used in the present disclosure have the same meaning as commonly understood by a person of ordinary skill in the art to which this application belongs. The terminology used in the specification herein is only for the purpose of describing specific embodiments and is not intended to limit the application. As used in the present disclosure, the term "and/or" used in the present disclosure includes any and all combinations of one or more of the associated listed items.

Some embodiments of the present disclosure will be described below in detail combining with drawings. The following examples and features thereof may be combined with each other without conflict.

With the increasing demand for energy conservation, emissions reduction and control of atmospheric pollution, the automotive industry needs to transform its energy structure as soon as possible. At present new energy vehicles are gradually becoming commercially available in the market, and electric vehicles and hybrid vehicles are the main force of new energy vehicles, with great future development potential and market demand. The on-board power supply, including an on-board charger (OBC), an on-board DC/DC converter, and a high voltage power distribution box (PDU), is an important component of the electric vehicle charging systems; wherein the on-board charger is a charger fixedly installed on the electric vehicle, which takes AC power as input and outputs DC power, charging the power battery directly, and realizing safe and automatic charging of the electric vehicle power battery.

In the prior art, an electromagnetic interference (EMI) filter module of the on-board charger and the main power board are mounted within the same large aluminum alloy cavity, and a shielding cover is mounted between the electromagnetic interference (EMI) filter module and the main power board to achieve shielding of the electromagnetic interference (EMI) filter module; when this method is adopted, there is a gap between the circumference of the shield cover and the housing, which poorly shields the electromagnetic interference (EMI) filter module and affects the electromagnetic compatibility (EMC) index of the whole machine.

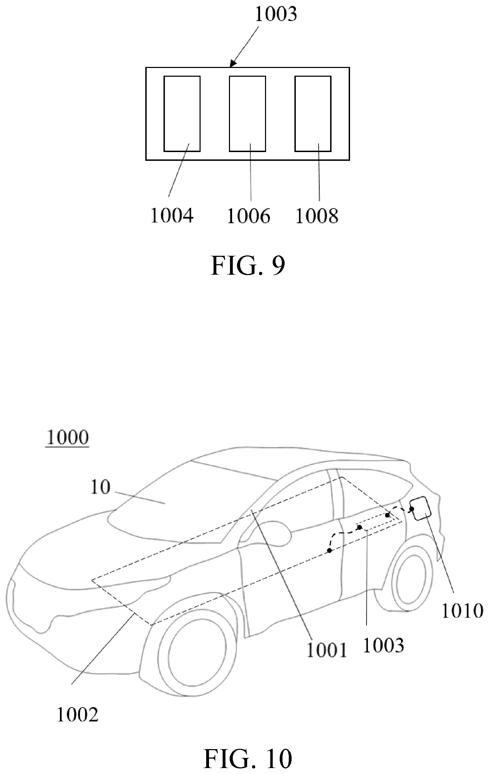

Referring to FIGS. 9 and 10, the present disclosure provides a vehicle 1000 including a vehicle body 1001 and an on-board power supply device 1003 mounted on the vehicle body 1001. The on-board power supply device 1003 plays an important role in converting and transmitting AC and DC energy, and provides power conversion support for the electric vehicle 1000. The vehicle 1000 also includes a vehicle windshield 10.

The present disclosure provides an on-board power supply device 1003, including an on-board converter 1004, a high voltage power distribution box 1006, and an on-board charger 1008. The on-board power supply device 1003 integrates the on-board converter 1004, the high voltage power distribution box 1006, and the on-board charger 1008, which is called a "small three-electric" system. The on-board converter (e.g., an on-board DC/DC converter) operates on the principle of converting high voltage side energy of the power battery 1002to low voltage side energy, powering full vehicle low voltage consumers (e.g. windows, wipers, lights, dashboards, etc.) and low voltage batteries. The high voltage power distribution box (PDU) 1006 is primarily responsible for the distribution of high voltage electrical energy of the power battery 1002 and the overload and short circuit protection of the high voltage circuits. The on-board charger 1008 mainly functions to meet slow charging needs of the electric vehicle 1000. The on-board charger 1008 is connected between a charging port socket 1010 of the vehicle 1000 and the power battery 1002, and the on-board charger 1008 operates on the principle of converting the single-phase AC power of 220V or three-phase AC power of 380V to the high-voltage DC power that can be used by the power battery 1002 according to the control signals of the Battery Management System (BMS) during AC charging, thereby charging the power battery 1002.

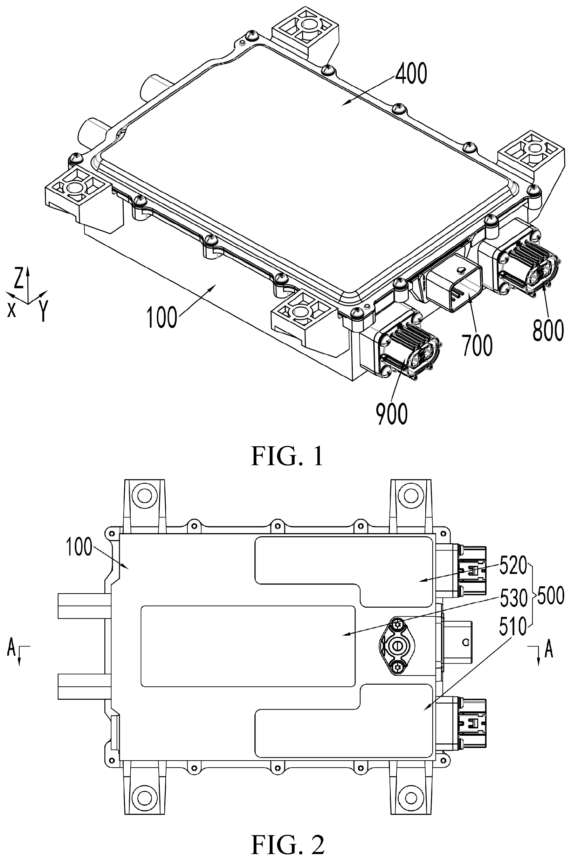

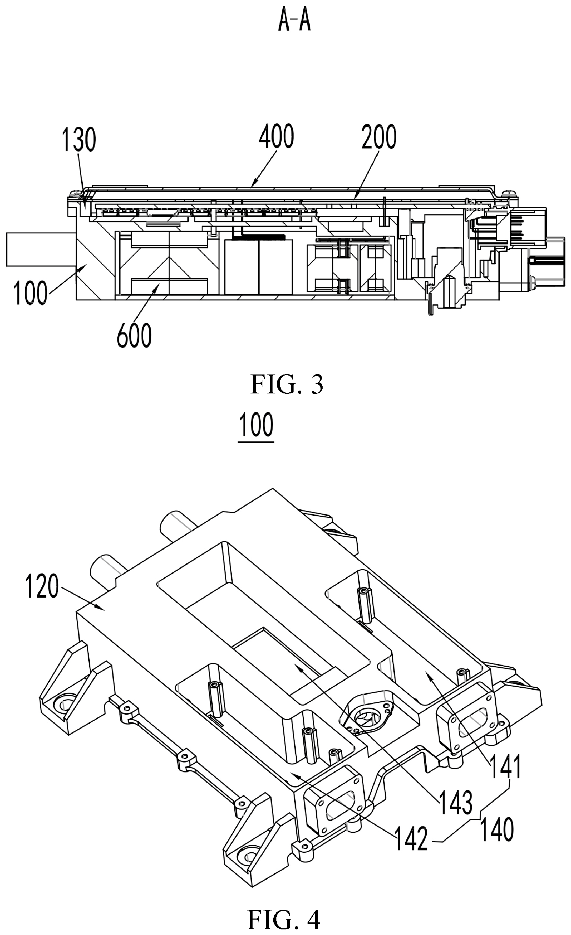

With reference to FIGS. 1, 2, 3, 4 and 5, the present disclosure provides an on-board charger 1008, including a housing 100, a circuit board 200, a filtering module 300 and a sealing member. The housing 100 includes a first side surface 110 and a second side surface 120 arranged opposite to each other. A first cavity 130 is recessed from the first side surface 110. A second cavity 140 is recessed from the second side surface 120. The first cavity 130 is spaced apart from the second cavity 140. The circuit board 20 is provided in the first cavity 130 and the filtering module 300 is provided in the second cavity 140.The filtering module 300 is electrically connected to the circuit board 200. The sealing member is connected to the housing 100, so as to enclose the circuit board 200 within the first cavity 130 and the filtering module 300 within the second cavity 140.

The on-board charger 1008 of the present disclosure is connected between a charging port slow charging socket of the vehicle 1000 and the power battery 1002.

When the electric vehicle 1000 is charged by slow charging, alternating current can be converted to direct current by the on-board charger 1008, to realize high-voltage DC charging of the power battery 1002. The electromagnetic compatibility (EMC) refers to the ability of an equipment or system to operate as required in its electromagnetic environment without producing intolerable electromagnetic harass to any equipment in its environment. The electromagnetic compatibility EMC includes two aspects of requirements: on the one hand, it means that the Electromagnetic Disturbance generated by the equipment to the environment during normal operation cannot exceed a certain limit; on the other hand, it means that the equipment has a certain degree of immunity to electromagnetic disturbance present in the environment, that is, Electromagnetic Susceptibility (EMS).

Specifically, through forming the first cavity 130on the first side surface 110 by recessing the first side 100 towards the side of the second side surface 120, forming the second cavity 140 by recessing the second side surface 120 towards the side of the first side surface 110, the first cavity 130 being spaced apart from the second cavity 140, housing the circuit board 200 and the filtering module 300 in the first cavity 130 and the second cavity 140, respectively, isolating the circuit board 200 and the filtering module 300 by the housing 100 itself, and enclosing the circuit board 200 and the filtering module 300 within the first cavity 130 and the second cavity 140, respectively, the on-board charger 1008 of the present disclosure achieves isolation of the circuit board 200 from the filtering module 300 to improve shielding effects of the filtering module 300 and reduce electromagnetic interference of the filtering module 300 by the circuit board 200, and improve electromagnetic compatibility (EMC) of the whole machine of the on-board charger 1008, and improve charging efficiency of the electric vehicle 1000.

The sealing member includes a first sealing lid 400 and a second sealing lid 500. The housing 100 may be a metal housing. The first sealing lid 400 and the second sealing lid 500 may both be metal sealing lids, exemplarily, may be aluminum alloys. While ensuring the structural strength of the charger, the electromagnetic waves are reflected, absorbed, or scattered, thereby reducing the propagation and impact of the electromagnetic waves. The first sealing lid 400 is connected to the first side surface 110 by screws. The circuit board 200 is a power board. The power board includes a high power amplifier, a power management circuitry, and a voltage stabilizing circuitry. The power board can convert an input low voltage and low current into a high voltage and high current output signal, realize stable output of the power supply and control of the output power, and can effectively protect the safety and stable operation of the electronic equipment. The filtering module 300 of the present disclosure is electrically connected to the circuit board 200.The filtering module 300 enables input and output of the power, reduces interference in the power and provides clean power supply to the power battery 1002 of the vehicle 1000.The filtering module 300 convert externally input low voltage power to appropriate high voltage power through the circuit board 200 to ensure proper operation of the power tool and vehicle.

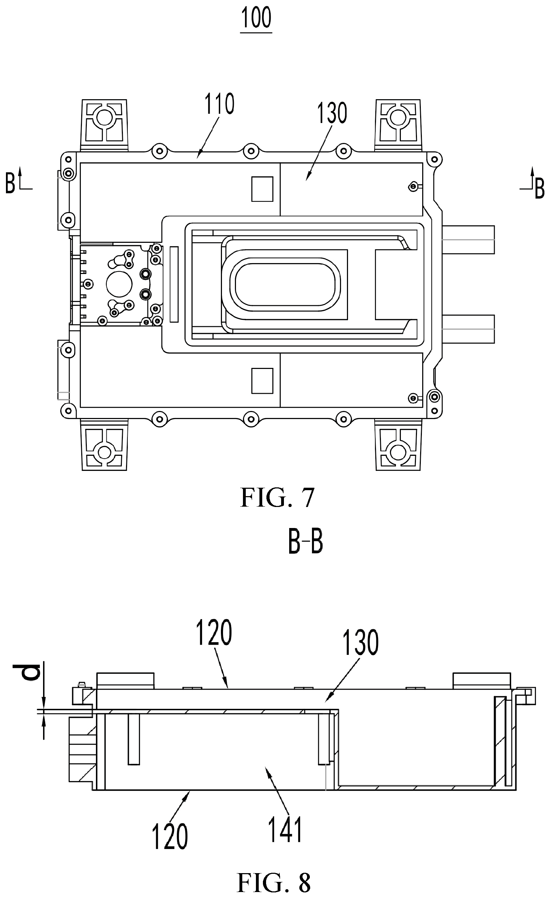

With reference to FIGS. 1, 5, 6, 7 and 8, the length direction of the housing 100 is X, the width direction of the housing 100 is Y, the height direction of the housing is Z. The first side surface 110 and the second side surface 120 are spaced apart along the height direction Z of the housing 100. The inner wall of the first cavity 130 and the inner wall of the second cavity 140 have a spacing d in the height direction Z of the housing 100, and d is greater than zero. The housing 100 in the embodiment of the present disclosure is provided integrally, and the portion of the housing 100 located between the first cavity 130 and the second cavity 140 isolates the circuit board 200 from the filtering module 300, that is, isolates the circuit board 200 from the filtering module 300 by its own structure of the housing 100, simplifies the structure of the on-board charger 1008, and improves the shielding effect of the circuit board 200 and the filtering module 300.

The on-board charger 1008 of the present disclosure also includes a magnetic element module 600. The filtering module 300 includes a DC filtering module 310 and an AC filtering module 320. The second cavity 140 includes a plurality of mutually isolated chambers. Specifically, the plurality of mutually isolated chambers includes a first chamber 141, a second chamber 142, and a third chamber 143. The DC filtering module 310 is arranged in the first chamber 141. The AC filtering module 320 is arranged in the second chamber 142. The magnetic element module 600 is arranged in the third chamber 143. The magnetic element module 600 is electrically connected to the circuit board 200. Specifically, the DC filtering module 310 and the AC filtering module 320 are fixed in the first chamber 141 and the second chamber 142 by screws, respectively. The magnetic element module 600 is potted in the third chamber 143 by potting glue to achieve the fixation of the magnetic element module 600. Separating the second cavity 140 into a plurality of chambers for accommodating the DC filtering module 310, the AC filtering module 320, and the magnetic element module 600, respectively, further improves the shielding effect of the on-board charger 1008.

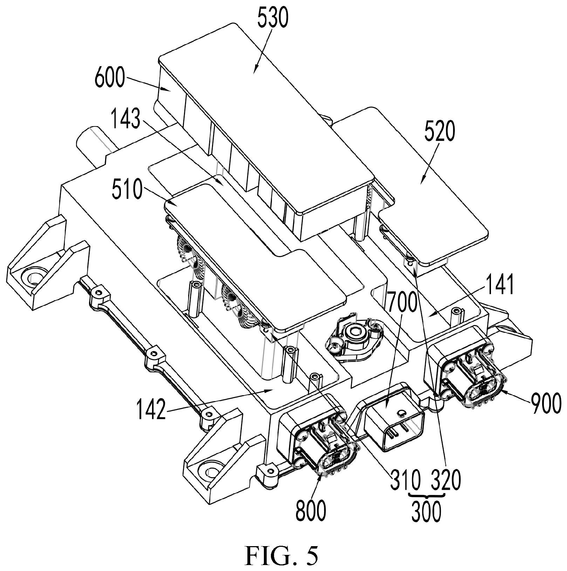

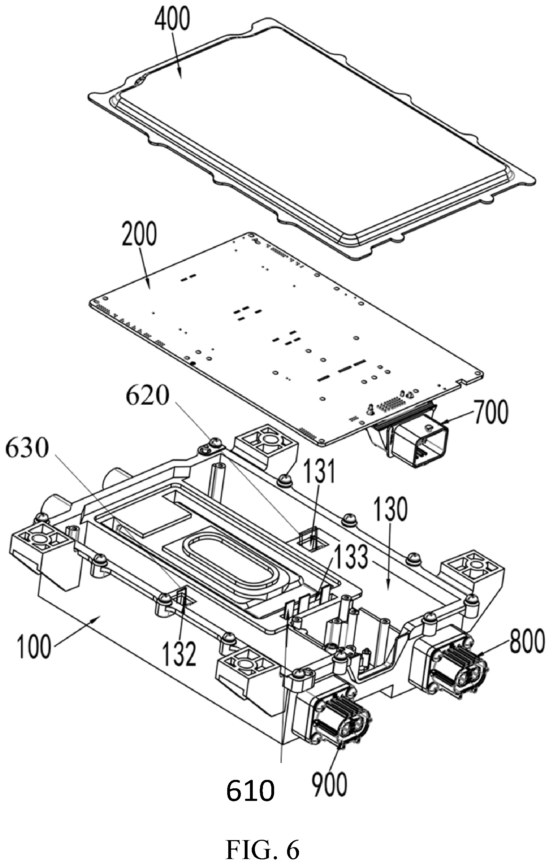

With reference to FIGS. 5 and 6, the on-board charger 1008 of the present disclosure further includes a plurality of connection terminals. The plurality of connection terminals are fixed to the housing 100 and/or the sealing member. One end of one of the connection terminals extends into the first cavity 130 and is electrically connected to the circuit board 200, and one end of another connection terminal extends into the second cavity 140 to electrically connect to the DC filtering module 310 and the AC filtering module 320. Specifically, the plurality of connection terminals may all be fixed to the housing 100 or the sealing member, or part of them are fixed to the housing 100, the other part of them are fixed to the sealing member. The circuit board 200 connects the wires by one of the connection terminals to connect to the system of the vehicle 1000, and the DC filtering module 310 and the AC filtering module 320 may share another connection terminal. It will be understood that sharing another connection terminal means that the DC filtering module 310 and the AC filtering module 320 are mounted on the same connection terminal, but the shared connection terminal is separated into DC and AC connection parts.

In one embodiment, three connection terminals are provided, namely, a first connection terminals 700, a second connection terminal 800 and a third connection terminal 900. One end of the first connection terminal 700 extends into the first cavity 130 to electrically connect the circuit board 200. One end of the second connection terminal 800 extends into the first cavity 141 to electrically connect the DC filtering module 310. One end of the third connection terminal 900 extends into the second cavity 142 to electrically connect the AC filtering module 320. The end of the first connection terminal 700 away from the circuit board 200 is connected to the system of the vehicle 1000 through a wire. The end of the second terminal 800 away from the DC filtering module 310is connected to the power battery 1002 of the vehicle 1000 through a wire to output power to the power battery 1002.The end of the third connection terminal 900 away from the AC filtering module 320 is connected to the charging port socket 1010 of the vehicle 1000 through a wire to achieve input of the power. Preferably, the first connection terminal 700, the second connection terminal 800, and the third connection terminal 900 are located at the same end in the length direction X of the housing 100 to facilitate wiring.

In one embodiment, a plurality of through holes are arranged on the inner wall of the first cavity 130. Each through hole communicates the first cavity 130 with one of the chambers. The plurality of through holes includes a first through hole 131, a second through hole 132 and a third through hole 133. The first through hole 131 communicates the first cavity 130 with the first chamber 141. The second through hole 132 communicates the first cavity 130 with the second chamber 142. The third through hole 133 communicates the first cavity 130 with the third chamber 143. A first conductive piece 620 is provided on the DC filtering module 310, and one end of the first conductive piece 620 passes through the first through hole 131 and is connected to the circuit board 200. A second conductive piece 630 is provided on the AC filtering module 320, and one end of second conductive piece 630 passes through the second through hole 132 and is connected to the circuit board 200. A third conductive piece 610 is provided on the magnetic element module 600. One end of the third conductive piece 610 passes through the third through hole 133 and is connected to the circuit board 200. Specifically, the circuit board 200 is mounted in the first cavity 130 and is located above the DC filtering module 310, the AC filtering module 320, and the magnetic element module 600. By forming the first through hole 131, the second through hole 132, and the third through hole 133 on the housing 100, through which the first conductive piece 620, the second conductive piece 630, and the third conductive piece 610, respectively, pass, to facilitate the connection of the DC filtering module 310, the AC filtering module 320, and the magnetic element module 600 to the circuit board 200. It will be noted that the size of the first through holes 131, the second through holes 132, and the third through holes 133 only need to be able to allow the first conductive piece 620, the second conductive piece 630, and the third conductive piece 610 to pass through, respectively.

Optionally, a first chamber 141, the third chamber 143 and the second chamber 142 are sequentially spaced apart along the width direction Y of the housing 100. The second sealing lid 500 includes a first lid plate 510, a second lid plate 520, and a third lid plate 530. The first lid plate 510 encloses the DC filtering module 310 within the first chamber 141. The second lid plate 520 encloses the AC filtering module 320 within the second chamber 142. The third lid plate 530 encloses the magnetic element module 600 within the third chamber 143. Specifically, the first lid plate 510, the second lid plate 520, and the third lid plate 530 are provided separately. The first lid plate 510, the second lid plate 520, and the third lid plate 530 cover the first chamber 141, the second chamber 142, and the third chamber 143, respectively, such that the first chamber 141, the second chamber 142, and the third chamber 143 are spaced apart, to accommodate the DC filtering module 310, the AC filtering module 320, and the magnetic element module 600, respectively, and to seal the DC filtering module 310, the AC filtering module 320, and the magnetic element module 600 by the first lid plate 510, the second lid plate 520, and the third lid plate 530, respectively, so as to enhance shielding effect of the DC filtering module 310, the AC filtering module 320, and the magnetic element module 600.

In one embodiment, the first lid plate 510 is mounted in the first chamber 141, and a side surface of the first lid plate 510 away from the first side surface 110 is in the same plane as the second side surface 120. The second lid plate 520 is mounted in the second chamber 142, and a side surface of the second lid plate 520 away from the first side surface 110 is in the same plane as the second side surface 120. A third lid plate 530 is mounted in the third chamber 143, and a side surface of the third lid plate 530 away from the first side surface 110 is in the same plane as the second side surface 120. Specifically, the first lid plate 510 and the housing 100, the second lid plate 520 and the housing 100, and the third lid plate 530 and the housing 100 can all be connected by stir friction welding, so that the connection between the first lid plate 510, the second lid plate 520, and the third lid plate 530 and the housing 100 is firm and the sealing effect is good. The exposed side surfaces of the first lid plate 510, the second lid plate 520 and the third lid plate 530 after installation are in the same plane as the second side surface 120 of the housing 100, thereby facilitating the welding of the first lid plate 510, the second lid plate 520, and the third lid plate 530 to the housing 100.

In the description of embodiments of the present disclosure, it will be noted that, the terms "central", "upper", "lower", "left", "right", "vertical", "horizontal", "inner", "outer" and the like refer to an orientation or positional relationship based on the orientation or positional relationship described in the drawings. It is merely for ease of description and simplicity of description, and is not intended to indicate or imply that the device or element referred to must have a particular orientation, be constructed and operate in a particular orientation, and therefore will not be understood as a limitation on the present disclosure.

What is disclosed above is only a preferred embodiment of the present disclosure, and it certainly cannot be used to limit the scope of the present disclosure. Those skilled in the art will understand that all or part of the processes of implementing the above embodiment and equivalent changes made according to the claims of the present disclosure are still within the scope covered by the present disclosure.

## Claims

1. An on-board charger (1008) comprising:
a housing (100) comprising a first side surface (110) and a second side surface (120) arranged opposite to each other, a first cavity (130) being recessed from the first side surface (110), a second cavity (140) being recessed from the second side surface (120), and the first cavity (130) being spaced apart from the second cavity (140);
a circuit board (200) being arranged in the first cavity (130);
a filtering module (300) being arranged in the second cavity (140), and electrically connected to the circuit board (200);
a sealing member being connected to the housing (100) to enclose the circuit board (200) within the first cavity (130) and the filtering module (300) within the second cavity (140).

2. The on-board charger (1008) according to claim 1, the first side surface (110) and the second side surface (120) being spaced apart along height direction of the housing (100), and inner wall of the first cavity (130) being spaced from inner wall of the second cavity (140) in height direction of the housing (100).

3. The on-board charger (1008) according to claim 1, the on-board charger (1008) further comprising a magnetic element module (600), the filtering module (300) comprising a DC filtering module (310) and an AC filtering module (320), the second cavity (140) comprising a plurality of mutually isolated chambers, and the plurality of chambers comprising a first chamber (141), a second chamber (142) and a third chamber (143), and the DC filtering module (310) being arranged in the first chamber (141), the AC filtering module (320) being arranged in the second chamber (142), and the magnetic element module (600) being arranged in the third chamber (143).

4. The on-board charger (1008) according to claim 3, a plurality of through holes being arranged on an inner wall of the first cavity (130), the plurality of through holes comprising a first through hole (131) communicating the first cavity (130) with the first chamber (141), a second through hole (132) communicating the first cavity (130) with the second chamber (142), and a third through hole (133) communicating the first cavity (130) with the third chamber (143).

5. The on-board charger (1008) according to claim 4, a first conductive piece (620) being arranged on the DC filtering module (310), one end of the first conductive piece (620) being connected to the circuit board (200) through the first through hole (131); a second conductive piece (630) being arranged on the AC filtering module (320), one end of the second conductive piece (630) being connected to the circuit board (200) through the second through hole (132); and a third conductive piece being arranged on the magnetic element module (600), one end of the third conductive piece being connected to the circuit board (200) through the third through hole (133).

6. The on-board charger (1008) according to claim 3, the plurality of chambers being sequentially spaced apart along width direction of the housing (100).

7. The on-board charger (1008) according to claim 3, the sealing member comprising a first sealing lid (400) and a second sealing lid (500), the first sealing lid (400) enclosing the circuit board (200) within the first cavity (130);
the second sealing lid (500) comprising a first lid plate (510), a second lid plate (520) and a third lid plate (530), the first lid plate (510) enclosing the DC filtering module (310) within the first chamber (141), the second lid plate (520) enclosing the AC filtering module (320) within the second chamber (142), and the third lid plate (530) enclosing the magnetic element module (600) within the third chamber (143).

8. The on-board charger (1008) according to claim 7, the first lid plate (510) being mounted in the first chamber (141), and a side surface of the first lid plate (510) away from the first side surface (110) being in the same plane as the second side surface (120); the second lid plate (520) being mounted in the second chamber (142), a side surface of the second lid plate (520) away from the first side surface (110) being in the same plane as the second side surface (120); and the third lid plate (530) being mounted in the third chamber (143), a side surface of the third lid plate (530) away from the first side surface (110) being in the same plane as the second side surface (120).

9. The on-board charger (1008) according to claim 3, the on-board charger (1008) further comprising a plurality of connection terminals, the plurality of connection terminals being fixed to the housing (100) and/or to the sealing member.

10. The on-board charger (1008) according to claim 9, the plurality of connection terminals comprising a first connection terminal (700), a second connection terminal (800), and a third connection terminal (900); one end of the first connection terminal (700) extending into the first cavity (130) to be in electrical connection with the circuit board (200), one end of the second connection terminal (800) extending into the first cavity (141) to be in electrical connection with the DC filtering module (310), and one end of the third connection terminal (900) extending into the second cavity (142) to be in electrical connection with the AC filtering module (320).

11. The on-board charger (1008) according to claim 10, an end of the first connection terminal (700) away from the circuit board (200) being connected to a system of a vehicle (1000) through a wire, an end of the second connection terminal (800) away from the DC filtering module (310) being connected to a power battery (1002) of the vehicle (1000) through a wire to output power to the power battery (1002), and an end of the third connection terminal (900) away from the AC filtering module (320) being connected to a charging port socket (1010) of the vehicle (1000) through a wire.

12. The on-board charger (1008) according to claim 11, the first connection terminal (700), the second connection terminal (800) and the third connection terminal (900) being located at the same end in length direction of the housing (100); or, the first connection terminal (700), the second connection terminal (800), the third connection terminal (900) being located at the same end in length direction of the sealing member.

13. The on-board charger (1008) according to claim 7, the housing (100) being a metal housing (100) and the first sealing lid (400) and the second sealing lid (500) being metal sealing lids.

14. An on-board power supply device (1003) comprising an on-board converter (1004), a high voltage power distribution box (1006) and the on-board charger (1008) according to any one of claims 1 to 13.

15. The on-board power supply device (1003) according to claim 14, the on-board converter (1004) being for converting high-voltage side energy of a power battery (1002) of a vehicle (1000) into low-voltage side energy; the high-voltage power distribution box (1006) being for distributing high-voltage electrical energy of the power battery (1002); and the on-board charger (1008) being connected between a charging port socket (1010) of the vehicle (1000) and the power battery (1002), and being configured to charge the power battery (1002).

16. A vehicle (1000) comprising a vehicle body (1001), a power battery (1002), a charging port socket (1010), and the on-board power supply device (1003) according to claims 14 or 15, the on-board power supply device (1003), the power battery (1002) and the charging port socket (1010) being mounted on the vehicle body (1001), the on-board charger (1008) being connected between the charging port socket (1010) and the power battery (1002) of the vehicle (1000), and the on-board charger (1008) being configured to charge the power battery (1002).
